# EUROPÄISCHE PATENTSCHRIFT

(11) **EP 0 957 582 B1**
(45) Veröffentlichungstag und Bekanntmachung des Hinweises auf die Patenterteilung: **17.10.2007**
(21) Anmeldenummer: 99109452.5
(22) Anmeldetag: 11.05.1999
(51) Int. Cl.: H03K 5/151

(54) **Schaltungsanordnung zur Erzeugung komplementärer Signale**
Circuit for generating complementary signals
Circuit pour générer des signaux complémentaires

(30) Priorität: 13.05.1998 DE 19821458
(43) Veröffentlichungstag der Anmeldung: 17.11.1999
(73) Patentinhaber: Infineon Technologies AG, 81669 München (DE)
(72) Erfinder: Heyne, Patrick, 81541 München (DE); Graetz, Thoralf, 80799 München (DE); Haerle, Dieter, 81541 München (DE); Johnson, Bret, 81737 München (DE)
(74) Vertreter: Müller - Hoffmann & Partner

(56) Entgegenhaltungen:
- EP-A- 0 310 232
- US-A- 4 617 477
- US-A- 5 140 174

## Beschreibung

Die vorliegende Erfindung betrifft eine Schaltungsanordnung zur Erzeugung komplementärer Signale, bei der ein Eingangssignal von einem Eingangsanschluß in einem ersten Zweig über ein Paßglied zu einem ersten Ausgangsanschluß und in einem zum ersten Zweig parallel liegenden zweiten Zweig über einen Inverter zu einem zweiten Ausgangsanschluß geführt ist.

Unter einem Paßglied ist dabei ein Glied mit einem Eingang und einem Ausgang, wie insbesondere ein Transfergatter oder auch ein Schalter, zu verstehen. Ein solches Paßglied kann als Beispiel aus der Parallelschaltung eines n-Kanal-MOS-Transistors mit einem p-Kanal-MOS-Transistor bestehen, deren Sources bzw. Drains jeweils zusammengeschaltet sind und deren Gates mit zueinander invertierten Signalen angesteuert werden, so daß das Paßglied abhängig vor dem Steuersignal entweder leitet oder sperrt.

Eine bestehende Schaltungsanordnung der eingangs genannten Art weist also im ersten Zweig ein Paßglied und im hierzu parallel liegenden zweiten Zweig einen Inverter auf, so daß über das Paßglied und den Inverter zueinander komplementäre Signale aus einem Eingangssignal gewonnen werden.

Eine solche Schaltungsanordnung ist einfach aufgebaut, da sie lediglich einen Inverter und ein Paßglied benötigt, um die komplementären Ausgangssignale zu liefern. Bei zeitkritischen Anwendungen zeigt die bestehende Schaltungsanordnung aber einen erheblichen Nachteil: Die Verzögerungen, die die Signale durch das Paßglied und den Inverter erfahren, weichen prozeßbedingt nicht unerheblich voneinander ab. Diese durch das Prozeßfenster bedingte zeitliche Abweichung der zueinander komplementären Signale läßt sich praktisch nicht beseitigen, was bei den erwähnten zeitkritischen Anwendungen, wie beispielsweise in einer DLL (Delayed Locked Loop bzw. verzögerungsverriegelte Schleife) äußerst unerwünscht ist. Das heißt, die bestehenden Schaltungsanordnungen aus einem Inverter und einem Paßglied können für Anwendungen von hoher Präzision nicht zufriedenstellend eingesetzt werden

EP-310232 offenbart eine Schaltung zur Erzeugung komplementärer Signale.

Es ist daher Aufgabe der vorliegenden Erfindung, eine Schaltungsanordnung zur Erzeugung komplementärer Signale zu schaffen, bei der diese komplementären Signale über das Prozeßfenster möglichst weitgehend miteinander übereinstimmen.

Diese Aufgabe wird bei einer Schaltungsanordnung der eingangs genannten Art erfindungsgemäß dadurch gelöst, daß der erste und der zweite Ausgangsanschluß über eine Ausgleicheinrichtung mit einem ersten bzw. zweiten Ausgangsknoten verbunden sind, und daß die Ausgleicheinrichtung die unterschiedlichen Zeitverzögerungen der Signale im ersten und im zweiten Zweig ausgleicht.

Damit beschreitet die Erfindung einen vom bisherigen Stand der Technik vollkommen abweichenden Weg: Anstelle Anstrengungen zu unternehmen, die durch Inverter bzw. Paßglied bedingten Zeitverzögerungen aneinander anzugleichen, wird die Trägheit der Ausgleicheinrichtung ausgenutzt, um die verschiedenen Zeitverzögerungen in den beiden Zweigen auszugleichen, so daß schließlich die Verzögerungen eines Eingangssignales zu den beiden Ausgangsknoten über das Prozeßfenster besser miteinander übereinstimmen.

Die Ausgleicheinrichtung besteht in vorteilhafter Weise aus weiteren Paßgliedern. Wie bereits eingangs erwähnt ist, kann jedes Paßglied aus einem n-Kanal-MOS-Transistor und einem zu diesem parallel liegenden p-Kanal-MOS-Transistor bestehen.

Eine Weiterbildung der Erfindung besteht darin, daß der Ausgangsanschluß des ersten Zweiges mit Gate eines ersten p-Kanal-MOS-Transistors eines ersten weiteren Paßgliedes, Gate eines ersten n-Kanal-MOS-Transistors eines zweiten weiteren Paßgliedes, Gate eines zweiten p-Kanal-MOS-Transistors eines dritten weiteren Paßgliedes und Gate eines zweiten n-Kanal-MOS-Transistors eines vierten weiteren Paßgliedes und der Ausgangsanschluß des zweiten Zweiges mit Gate eines dritten n-Kanal-MOS-Transistors des ersten weiteren Paßgliedes, Gate eines dritten p-Kanal-MOS-Transistors des zweiten weiteren Paßgliedes, Gate eines vierten n-Kanal-MOS-Transistors des dritten weiteren Paßgliedes und Gate eines vierten p-Kanal-MOS-Transistors des vierten weiteren Paßgliedes verbunden sind, und daß die Ausgangsanschlüsse der ersten und zweiten weiteren Paßglieder mit dem ersten Ausgangsknoten und die Ausgangsanschlüsse des dritten und vierten weiteren Paßgliedes mit dem zweiten Ausgangsknoten verbunden sind. An den Eingangsanschlüssen des ersten und des vierten Paßgliedes liegt dabei eine erste Versorgungsspannung, während an den Eingangsanschlüssen des zweiten und dritten Paßgliedes eine zweite Versorgungsspannung anliegt.

Die Erfindung verwendet so Paßglieder bzw. Transfergatter, deren Eingänge auf der ersten bzw. zweiten Versorgungsspannung und damit auf festem Potential liegen, um in den Zeitverzögerungen ausgeglichene komplementäre Signale an den beiden Ausgangsknoten zu generieren. Durch die vier weiteren Paßglieder ist zwar der Schaltungsaufwand gegenüber der bestehenden Schaltungsanordnung vergrößert. Dieser Aufwand kann aber in Kauf genommen werden, wenn, wie beispielsweise bei einer DLL, zeitkritische Anwendungen vorliegen, die eine hohe zeitliche Präzision der komplementären Signale erfordern.

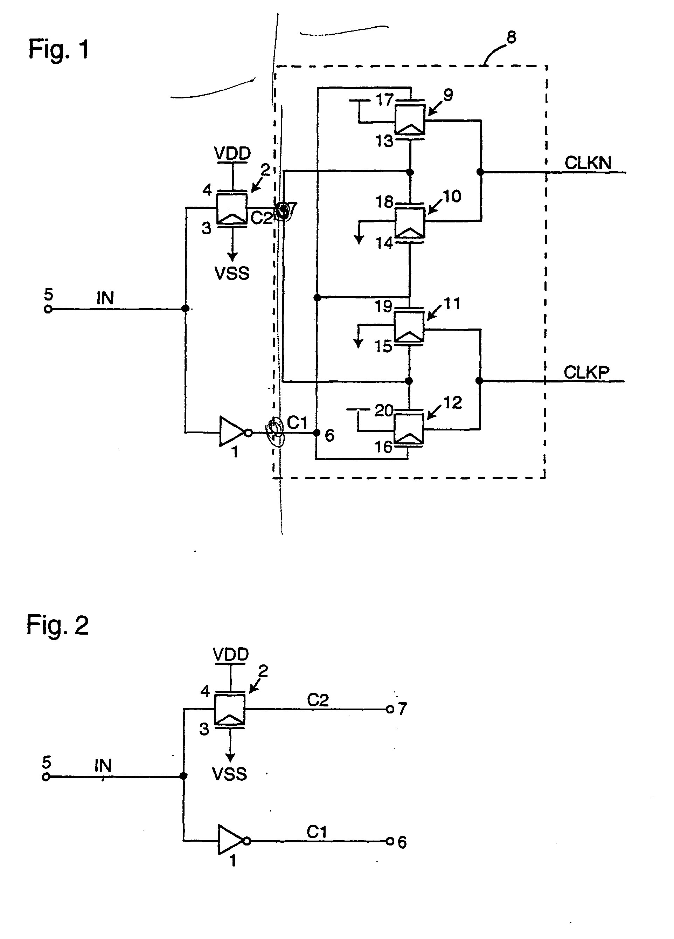

Fig. 2 zeigt eine bestehende Schaltungsanordnung mit einem Inverter 1 und einem Tastglied 2 aus einem p-Kanal-MOS-Transistor 3 und einem n-Kanal-MOS-Transistor 4. Die Transistoren 3 und 4 sind jeweils mit Source bzw. Drain zusammengeschaltet und liegen so parallel zueinander. Die Gates der Transistoren 3, 4 sind mit den festen Potentialen der Versorgungsspannungen VSS bzw. VDD beaufschlagt.

Ein Eingangssignal IN wird von einem Eingangsanschluß 5 über den Inverter 1 bzw. das Paßglied 2 zu einem ersten Ausgangsanschluß 6 bzw. zu einem zweiten Ausgangsanschluß 7 geschickt. Infolge der durch das Prozeßfenster bedingten verschiedenen Verzögerungen durch den Inverter 1 bzw. das Paßglied 2 sind daher Signale C1 bzw. C2 an den Ausgangsanschlüssen 6 und 7 nicht zeitgleich, sondern weichen zeitlich erheblich voneinander ab, was die zeitkritischen Anwendungen, wie beispielsweise einer DLL, äußerst nachteilhaft ist.

Nachfolgend wird die Erfindung anhand der Zeichnungen näher erläutert. Es zeigen:
- Fig. 1: ein Ausführungsbeispiel der erfindungsgemäßen Schaltungsanordnung und
- Fig. 2: ein Schaltbild der bestehenden Schaltungsanordnung.

Fig. 2 ist bereits eingangs erläutert worden. In Fig. 1 werden für einander entsprechende Bauteile die gleichen Bezugszeichen wie in Fig. 2 verwendet.

Die Erfindung sieht zusätzlich an den Ausgangsanschlüssen 6, 7 eine Ausgleicheinrichtung 8 vor, die die Zeitverzögerungen zwischen den Signalen C1 und C2 ausgleicht, so daß die Verzögerung des Eingangssignales IN zu Ausgangsknoten CLKN bzw. CLKP besser übereinstimmen.

Im einzelnen besteht die Ausgleicheinrichtung 8 aus weiteren Paßgliedern 9, 10, 11, 12, die jeweils p-Kanal-MOS-Transistoren 13, 14, 15 und 16 und n-Kanal-MOS-Transistoren 17, 18, 19 und 20 aufweisen. Die Ausgangsanschlüsse der Paßglieder 9, 10 sind mit dem Ausgangsknoten CLKN verbunden, während die Ausgangsanschlüsse der Paßglieder 11, 12 mit dem Ausgangsknoten CLKP verbunden sind. An den Eingangsanschlüssen der Paßglieder 9, 12 liegt die Versorgungsspannung VDD, während an den Eingangsanschlüssen der Paßglieder 10, 11 die Versorgungsspannung VSS anliegt.

Ist beispielsweise der Ausgangsanschluß C1 auf "0", so leiten die p-Kanal-MOS-Transistoren 14 und 16, während die n-Kanal-MOS-Transistoren 17 und 19 sperren. In diesem Fall ist das Ausgangssignal C2 "hoch", so daß die p-Kanal-MOS-Transistoren 18 und 13 sperren, während die n-Kanal-MOS-Transistoren 18 und 20 leiten. Das heißt, die Paßglieder 10 und 12 leiten, während die Paßglieder 9 und 11 sperren. Bei umgekehrter Polung der Ausgangsanschlüsse 6 und 7, also bei "hohem" Ausgangssignal C1 und "niedrigem" Ausgangssignal C2 leiten die Paßglieder 9, 11, während die Paßglieder 10, 12 sperren.

In jedem Fall wird also das Eingangssignal IN nach Durchlaufen des Inverters 1 bzw. des Paßgliedes 2 durch die Ausgleicheinrichtung 8 geführt, welche durch ihre Trägheit die Zeitverzögerungen zwischen den Ausgangssignalen C1 und C2 des Inverters 1 bzw. des Paßgliedes 2 ausgleicht, so daß an den Ausgangsknoten CLKP bzw. CLKN Signale erhalten werden, deren Verzögerungen besser übereinstimmen.

## Patentansprüche

1. Schaltungsanordnung zur Erzeugung komplementärer Signale, bei der ein Eingangssignal (IN) von einem Eingangsanschluss (5) in einem ersten Zweig über ein Passglied (2) zu einem ersten Ausgangsanschluss (7) und in einem zum ersten Zweig parallel liegenden zweiten Zweig über einen Inverter (1) zu einem zweiten Ausgangsanschluss (6) geführt ist,
**dadurch gekennzeichnet,**
**dass** der erste Ausgangsanschluss (7) des ersten Zweiges mit Gate eines ersten p-Kanal-MOS-Transistors (13) eines ersten weiteren Passgliedes (9), Gate eines ersten n-Kanal-MOS-Transistors (18) eines zweiten weiteren Passgliedes (10), Gate eines zweiten p-Kanal-MOS-Transistors (15) eines dritten weiteren Passgliedes (11) und Gate eines zweiten n-Kanal-MOS-Transistors (20) eines vierten weiteren Passgliedes (12) und der zweite Ausgangsanschluss (6) des zweiten Zweiges mit Gate eines dritten n-Kanal-MOS-Transistors des ersten weiteren Passgliedes (9), Gate eines dritten p-Kanal-MOS-Transistors (14) des zweiten weiteren Passgliedes (10), Gate eines vierten n-Kanal-MOS-Transistors (19) des dritten weiteren Passgliedes (11) und Gate eines vierten p-Kanal-MOS-Transistors (16) des vierten weiteren Passgliedes (12) verbunden sind, und dass die Ausgangsanschlüsse des ersten und zweiten weiteren Passgliedes (9, 10) mit einem ersten Ausgangsknoten (CLKN) und die Ausgangsanschlüsse des dritten und vierten weiteren Passgliedes (11, 12) mit einem zweiten Ausgangsknoten (CLKP) verbunden sind.

2. Schaltungsanordnung nach Anspruch 1,
**dadurch gekennzeichnet,**
**dass** jedes Passglied (2; 9 bis 12) aus einem n-Kanal-MOS-Transistor (4; 17 bis 20) und einem zu diesem parallel liegenden p-Kanal-MOS-Transistor (3; 13 bis 16) besteht.

3. Schaltungsanordnung nach Anspruch 1 oder 2,
**dadurch gekennzeichnet,**
**dass** an den Eingangsanschlüssen des ersten und vierten weiteren Passgliedes (9, 12) eine erste Versorgungsspannung (VDD) und an den Eingangsanschlüssen des zweiten und dritten weiteren Passgliedes (10, 11) eine zweite Versorgungsspannung (VSS) anliegen.

## Claims

1. Circuit arrangement for producing complementary signals, in which an input signal (IN) from an input connection (5) is routed on a first path to a first output connection (7) via a pass element (2) and on a second path, connected in parallel with the first path, to a second output connection (6) via an inverter (1), **characterized in that** the first output connection (7) of the first path is connected to the gate of a first p-channel MOS transistor (13) in a first further pass element (9), the gate of a first n-channel MOS transistor (18) in a second further pass element (10), the gate of a second p-channel MOS transistor (15) in a third further pass element (11) and the gate of a second n-channel MOS transistor (20) in a fourth further pass element (12), and the second output connection (6) of the second path is connected to the gate of a third n-channel MOS transistor in the first further pass element (9), the gate of a third p-channel MOS transistor (14) in the second further pass element (10), the gate of a fourth n-channel MOS transistor (19) in the third further pass element (11) and the gate of a fourth p-channel MOS transistor (16) in the fourth further pass element (12), and **in that** the output connections of the first and the second further pass element (9, 10) are connected to a first output node (CLKN), and the output connections of the third and the fourth further pass element (11, 12) are connected to the second output node (CLKP).

2. Circuit arrangement according to Claim 1, **characterized in that** each pass element (2; 9 to 12) comprises an n-channel MOS transistor (4; 17 to 20) and a p-channel MOS transistor (3; 13 to 16) connected in parallel with the latter.

3. Circuit arrangement according to Claim 1 or 2, **characterized in that** the input connections of the first and the fourth further pass element (9, 12) are connected to a first supply voltage (VDD), and the input connections of the second and the third further pass element (10, 11) are connected to a second supply voltage (VSS).

## Revendications

1. Circuit de production de signaux complémentaires, dans lequel un signal (IN) d'entrée est acheminé d'une borne (5) d'entrée à une première borne (7) de sortie dans une première branche en passant par un élément (2) d'adaptation et à une deuxième borne (6) de sortie dans une deuxième branche parallèle à la première branche en passant par un inverseur (1),
**caractérisé**
**en ce que** la première borne (7) de sortie de la première branche est reliée à la grille d'un premier transistor MOS (13) à canal p d'un premier autre élément (9) d'adaptation, à la grille d'un premier transistor MOS (18) à canal n, d'un deuxième autre élément (10) d'adaptation, à la grille d'un deuxième transistor MOS (15) à canal p, d'un troisième autre élément (11) d'adaptation et à la grille d'un deuxième transistor MOS (20) à canal n d'un quatrième autre élément (12) d'adaptation et la deuxième borne (6) de sortie de la deuxième branche est reliée à la grille d'un troisième transistor MOS à canal n du premier autre élément (9) d'adaptation, à la grille d'un troisième transistor MOS (14) à canal p du deuxième autre élément (10) d'adaptation, à la grille d'un quatrième transistor MOS (19) à canal n du troisième autre élément (11) d'adaptation, et à la grille d'une quatrième transistor MOS à canal p du quatrième autre élément (12) d'adaptation et en ce que les bornes de sorties du premier et du deuxième autre élément (9, 10) d'adaptation sont reliées à un premier noeud (CLKN) de sortie et les bornes de sortie du troisième et quatrième autre élément (11, 12) d'adaptation à un deuxième noeud (CLKP) de sortie.

2. Circuit suivant la revendication 1,
**caractérisé en ce que** chaque élément (2 ; 9 à 12) d'adaptation est constitué d'un transistor MOS (4 ; 17 à 20) à canal n et d'un transistor MOS (3 ; 13 à 16) à canal p monté en parallèle à celui-ci.

3. Circuit suivant la revendication 1 ou 2,
**caractérisé**
**en ce qu'**il est appliqué, aux bornes d'entrée du premier et quatrième autre élément (9, 12) d'adaptation, une première tension (VDD) d'alimentation et, aux bornes d'entrée du deuxième et troisième autre élément (10, 11) d'adaptation, une deuxième tension (VSS) d'alimentation.
